# EUROPEAN PATENT SPECIFICATION

(11) **EP 2 197 804 B1**
(45) Date of publication and mention of the grant of the patent: **30.05.2012**
(21) Application number: 08831828.2
(22) Date of filing: 13.08.2008
(51) Int. Cl.: C03C 17/00, G02B 1/11, H01L 31/0216

(54) **METHOD OF MAKING AN ANTIREFLECTIVE SILICA COATING, RESULTING PRODUCT, AND PHOTOVOLTAIC DEVICE COMPRISING SAME**
VERFAHREN ZUR HERSTELLUNG EINER SILICIUMDIOXID-ANTIREFLEXIONSBESCHICHTUNG, RESULTIERENDES PRODUKT UND PHOTOVOLTAISCHE VORRICHTUNG DAMIT
PROCÉDÉ DE FABRICATION D'UN REVÊTEMENT DE SILICE ANTIREFLET, PRODUIT RÉSULTANT ET DISPOSITIF PHOTOVOLTAÏQUE LE COMPRENANT

(30) Priority: 18.09.2007 US 902072
(43) Date of publication of application: 23.06.2010
(73) Proprietor: Guardian Industries Corp., Auburn Hills, MI 48326-1714 (US)
(72) Inventor: VARAPRASAD, Desaraju, V., Ann Arbor MI 48108 (US)
(74) Representative: Hess, Peter K. G.
(86) International application number: PCT/US2008/072950
(87) International publication number: WO 2009/038903

(56) References cited:
- DE-A1-102005 020 168
- US-A1- 2007 074 757
- US-B1- 6 395 331
- KULKARNI S A; MIRHI A S; MANDALE A B; VIJAYAMOHANAN K P: "Thermal Stability of self-assembled octadecyltrichlorosilane monolayers on planar and curved silica surfaces" THIN SOLID FILMS, vol. 496, 2006, pages 420-425, XP005184845
- XU G-H; HIGASHITANI K: "Formation of OTS Self-Assembled Monolayer on Glass Surface Investigated by AFM" JOURNAL OF ZHEJIANG UNIVERSITY SCIENCE, vol. 1, no. 2, 2000, pages 162-170, XP002504351
- NIE H-Y; MILLER D J; FRANCIS J T; WALZAK M J; MCINTYRE N S: "Robust Self-Assembled Octadecylphosphonic Acid Monolayers on a Mica Substrate" LANGMUIR, vol. 21, 2005, pages 2773-2778, XP002504245

## Description

This invention relates to a method of making a low-index silica coating having a surface treatment or overcoat layer. The coating may comprise an antireflective (AR) coating supported by a glass substrate for use in a photovoltaic device or the like in certain example embodiments. The surface treatment or overcoat layer includes organic materials.

### BACKGROUND OF THE INVENTION

Glass is desirable for numerous properties and applications, including optical clarity and overall visual appearance. For some example applications, certain optical properties (e.g., light transmission, reflection and/or absorption) are desired to be optimized. For example, in certain example instances, reduction of light reflection from the surface of a glass substrate may be desirable for storefront windows, display cases, photovoltaic devices (e.g., solar cells), picture frames, other types of windows, greenhouses, and so forth.

Photovoltaic devices such as solar cells (and modules therefor) are known in the art. Glass is an integral part of most common commercial photovoltaic modules, including both crystalline and thin film types. A solar cell/module may include, for example, a photoelectric transfer film made up of one or more layers located between a pair of substrates. One or more of the substrates may be of glass, and the photoelectric transfer film (typically semiconductor) is for converting solar energy to electricity. Example solar cells are disclosed in U.S. Patent Nos. 4,510,344, 4,806,436, 6,506,622, 5,977,477, and JP 07-122764.

Substrate(s) in a solar cell/module are sometimes made of glass. Incoming radiation passes through the incident glass substrate of the solar cell before reaching the active layer(s) (e.g., photoelectric transfer film such as a semiconductor) of the solar cell. Radiation that is reflected by the incident glass substrate does not make its way into the active layer(s) of the solar cell, thereby resulting in a less efficient solar cell. In other words, it would be desirable to decrease the amount of radiation that is reflected by the incident substrate, thereby increasing the amount of radiation that makes its way to the active layer(s) of the solar cell. In particular, the power output of a solar cell or photovoltaic (PV) module maybe dependant upon the amount of light, or number of photons, within a specific range of the solar spectrum that pass through the incident glass substrate and reach the photovoltaic semiconductor.

Because the power output of the module may depend upon the amount of light within the solar spectrum that passes through the glass and reaches the PV semiconductor, certain attempts have been made in an attempt to boost overall solar transmission through the glass used in PV modules. One attempt is the use of iron-free or "clear" glass, which may increase the amount of solar light transmission when compared to regular float glass, through absorption minimization.

In certain example embodiments of this invention, an attempt to address the aforesaid problem(s) is made using an antireflective (AR) coating on a glass substrate (the AR coating may be provided on either side of the glass substrate in different embodiments of this invention). An AR coating may increase transmission of light through the light incident substrate, and thus the power of a PV module in certain example embodiments of this invention.

In many instances, glass substrates have an index of refraction of about 1.52, and typically about 4% of incident light may be reflected from the first surface. Single-layered coatings of transparent materials such as silica and alumina having a refractive index of equal to the square root of that of glass (e.g., about 1.23) may be applied to minimize reflection losses and enhance percentage of light transmission. The refractive indices of silica and alumina are, respectively, about 1.46 and 1.6 and thus may not meet this low index requirement.

Because refractive index is related to the density of coating, it may be possible to reduce it by introducing porosity. Prior techniques that attempt to lower the refractive index of coatings of silica and alumina may include introducing micro porosity in order to lower the refractive index of coatings. Pore size and distribution of pores may significantly affect to achieve desired optical properties: Pores may preferably be distributed homogeneously, and the pore size may preferably be substantially smaller than the wavelength of light to be transmitted. In many instances, it is believed that about 53% porosity may be required in order to lower the refractive index of silica coatings from about 1.46 to about 1.2 and that about 73% porosity may be required to achieve alumina coatings of the same low index.

The mechanical durability of coatings, however, may be adversely affected with increasing porosity. Porous coatings also tend to be prone for scratches, mars etc. Thus there may exist a need for methods and coatings that enhance the mechanical durability of single-layered AR coatings.

Methods of making multilayered antireflective coatings deposited by vacuum deposition process may be known to deposit a lubricating layer to enhance mechanical durability. See U.S. Patent Nos. 5,744,227 and 5,783,049.
Document D1 discloses a porous anti-reflective layer comprising a metal, metal oxide, zinc oxide, tin oxide, aluminum oxide and/or their mixtures, especially a silicon-aluminum mixed oxide. A hydrophobic substance is deposited on the anti-reflective layer, at least locally. It is introduced into pores of the layer, forming a coating and/or total-area internal coating. The hydrophobe, especially being a silica sol, is present as a component of the sol-gel binder. The anti-reflective layer includes porous nanoparticles. Their grain size is preferably about 8 nm. The porosity of the nanoparticles amounts to 10%-60% of the total volume of the layer. Coating onto the substrate is by a spraying, immersion, wiping, painting or spreading process.

It is an object of this invention to provide materials that are suitable for application as protective top coats for single-layered AR coatings. It is another object of this invention to provide a method which could be used in-line in order to impart lubricity to surface and thereby enhance scratch resistance of AR coatings.
The above objects are solved by a method according to claim 1 and a photovoltaic device according to claim 5.

### BRIEF SUMMARY OF EXAMPLE EMBODIMENTS OF THE INVENTION

According to this invention, there is provided a method of making a low-index silica based coating, the method including: forming a silica precursor comprising a silica sol comprising a silane and/or a colloidal silica; depositing the silica precursor on a glass substrate to form a coating layer; curing and/or firing the coating layer in an oven at a temperature of from about 550 to 700°C for a duration of from about 1 to 10 minutes; forming a surface treatment composition comprising an organic material comprising an alkyl chain or a fluoro-alkyl chain and at least one reactive functionality comprising silicon and/or phosphorous; namely octadecyl phosphonic acid; depositing the surface treatment composition on the coating layer; and curing and/or firing the surface treatment composition to form an overcoat layer.

In certain reference examples, there is a photovoltaic device such as a solar cell comprising: a photoelectric transfer film and a low-index coating having an overcoat layer acting as a surface treatment, wherein the low-index coating is provided on a light incident side of a front glass substrate of the photovoltaic device.

In certain reference examples, there is a method for making a photovoltaic device including a low-index silica based coating used in an antireflective coating that includes: forming a silica precursor comprising a silica sol comprising a silane and/or a colloidal silica; depositing the silica precursor on a glass substrate to form a coating layer; curing and/or firing the coating layer in an oven at a temperature of from about 550 to 700°C for a duration of from about 1 to 10 minutes; forming a surface treatment composition comprising an organic material comprising an alkyl chain or a fluoro-alkyl chain and at least one reactive functionality comprising silicon and/or phosphorous; depositing the surface treatment on the coating layer; curing and/or firing the surface treatment to form an overcoat layer; and using the glass substrate with the low-index silica based coating thereon as a front glass substrate of the photovoltaic.device so that the low-index silica based coating is provided on a light incident side of the glass substrate.

According to this invention, there is a photovoltaic device comprising: a photovoltaic film, and at least a glass substrate on a light incident side of the photovoltaic film; an antireflection coating provided on the glass substrate; wherein the antireflection coating comprises at least a layer provided directly on and contacting the glass substrate, the layer produced using a method comprising the steps of: forming a silica precursor comprising a silica sol comprising a silane and/or a colloidal silica; depositing the silica precursor on a glass substrate to form a coating layer; curing and/or firing the coating layer in an oven at a temperature of from about 550 to 700°C for a duration of from about 1 to 10 minutes; forming a surface treatment composition comprising an organic material comprising an alkyl chain or a fluoro-alkyl chain and at least one reactive functionality comprising silicon and/or phosphorous; namely octadecyl phosphonic acid; depositing the surface treatment on the coating layer; curing and/or firing the surface treatment to form an overcoat layer; and using the glass substrate with the low-index silica based coating thereon as a front glass substrate of the photovoltaic device so that the low-index silica based coating is provided on a light incident side of the glass substrate.

In certain reference examples, there is a coated article comprising: a glass substrate; an antireflection coating provided on the glass substrate; wherein the antireflection coating comprises at least a layer provided directly on and contacting the glass substrate, the layer produced using a method comprising the steps of: forming a silica precursor comprising a silica sol comprising a silane and/or a colloidal silica; depositing the silica precursor on a glass substrate to form a coating layer; curing and/or firing the coating layer in an oven at a temperature of from about 5 50 to 700°C for a duration of from about 1 to 10 minutes; forming a surface treatment composition comprising an organic material comprising an alkyl chain or a fluoro-alkyl chain and at least one reactive functionality comprising silicon and/or phosphorous; depositing the surface treatment on the coating layer; curing and/or firing the surface treatment to form an overcoat layer; and using the glass substrate with the low-index silica based coating thereon as a front glass substrate of the photovoltaic device so that the low-index silica based coating is provided on a light incident side of the glass substrate.

In reference examples the organic materials containing alkyl chains or fluoro-alkyl chains and reactive functionalities comprising silicon and/or phosphorous may be selected from at least one of the following: octadecyl trichlorosilane, octadecyl triethoxy silane, methyl trichlorosilane, a dipodal silane having dual reactive sites, bis(triethoxysilyl)decane, tridecafluoro tetrahydrooctyl trichlorosilane, tridecafluoro tetrahydrooctyl triethoxy silane, methyl phosphonic acid, fluorinated polyether materials, a perfluoropolyether containing reactive silane groups, a perfluoropolyether based polyurethane dispersion, a diphosphate derivative of perfluoropolyether, and/or a microemulsion of hydroalcoholic perfluoropolyether. According to the invention the surface treatment composition includes octadecyl phosphonic acid.

In reference examples, the low-index coating has a percent transmission and/or percent reflection that is not substantially affected by the overcoat layer comprising the organic materials containing alkyl chains or fluoro-alkyl chains and reactive functionalities comprising silicon and/or phosphorous.

### BRIEF DESCRIPTION OF THE DRAWINGS

Figure 1 is a cross sectional view of a coated article including an antireflective (AR) coating made in accordance with an example embodiment of this invention (this coated article of Fig. 1 may be used in connection with a photovoltaic device or in any other suitable application in different embodiments of this invention).

Figure 2 is a cross sectional view of a photovoltaic device that may use the AR coating of Figure 1.

Figure 3 shows transmission and reflection spectra of coatings made in accordance with example embodiments of the present invention as well as comparative coatings.

### DETAILED DESCRIPTION OF EXEMPLARY EMBODIMENTS OF THE INVENTION

Referring now more particularly to the accompanying drawings in which like reference numerals indicate like parts throughout the several views.

This invention relates to antireflective (AR) coatings that may be provided for in coated articles used in devices such as photovoltaic devices, storefront windows, display cases, picture frames, greenhouses, other types of windows, and the like. In certain example embodiments (e.g., in photovoltaic devices), the AR coating may be provided on either the light incident side or the other side of a substrate (e.g., glass substrate), such as a front glass substrate of a photovoltaic device. In other example embodiments, the AR coatings described herein may be used in the context of sport and stadium lighting (as an AR coating on such lights), and/or street and highway lighting (as an AR coating on such lights).

In certain example embodiments of this invention, an improved anti-reflection (AR) coating is provided on an incident glass substrate of a solar cell or the like. This AR coating may function to reduce reflection of light from the glass substrate, thereby allowing more light within the solar spectrum to pass through the incident glass substrate and reach the photovoltaic semiconductor so that the solar cell can be more efficient. In other reference examples, such an AR coating is used in applications other than photovoltaic devices (e.g., solar cells), such as in storefront windows, display cases, picture frames, greenhouse glass/windows, solariums, other types of windows, and the like. The glass substrate may be a glass superstrate or any other type of glass substrate in different instances.

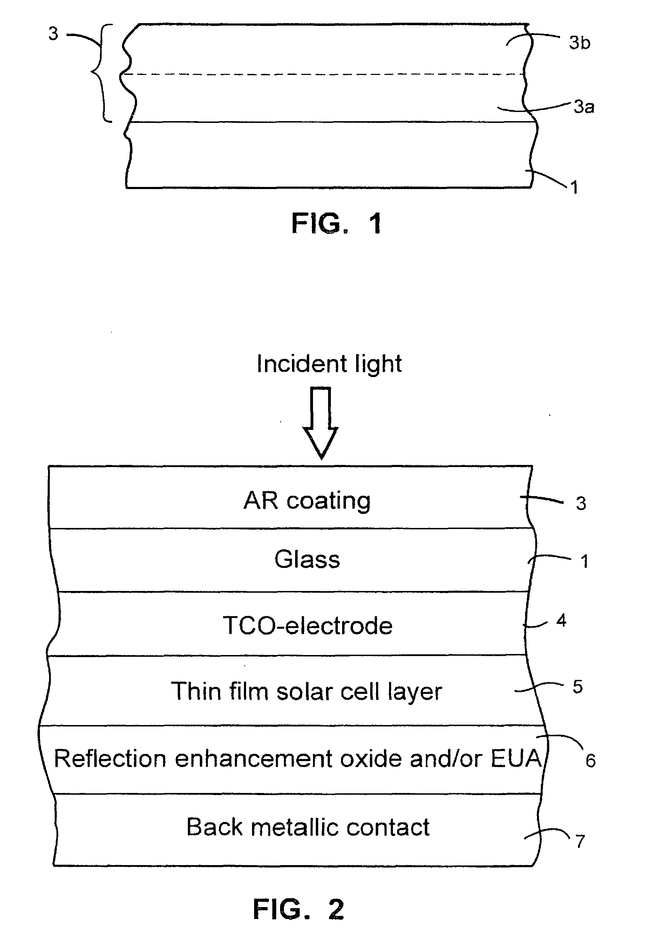

Figure 1 is a cross sectional view of a coated article according to an example embodiment of this invention. The coated article of Figure 1 includes a glass substrate 1 and an AR coating 3. The AR coating includes a first layer 3a and an overcoat layer 3b.

In the Fig. 1 embodiment, the antireflective coating 3 includes first layer 3a a comprising a silane and/or a colloidal silica. The first layer 3a maybe any suitable thickness in certain example embodiments of this invention. However, in certain example embodiments, the first layer 3a of the AR coating 3 has a thickness of approximately 500 to 4000 Å after firing.

The AR coating 3 also includes an surface treatment layer 3b of or including a surface treatment composition, which is provided over the first layer 3a in certain example embodiments of this invention as shown in Fig. 1. It is possible to form other layer(s) between layers 3a and 3b, and/or between glass substrate 1 and layer 3a, in different example embodiments of this invention.

In certain example embodiments of this invention, high transmission low-iron glass may be used for glass substrate 1 in order to further increase the transmission of radiation (e.g., photons) to the active layer of the solar cell or the like. For example and without limitation, the glass substrate 1 may be of any of the glasses described in any of U.S. Patent Application Serial Nos. 11/049,292 and/or 11/122,218. Furthermore, additional suitable glasses include, for example (i.e., and without limitation): standard clear glass; and/or low-iron glass, such as Guardian's ExtraClear, UltraWhite, or Solar. No matter the composition of the glass substrate, certain embodiments of anti-reflective coatings produced in accordance with the present invention may increase transmission of light to the active semiconductor film of the photovoltaic device.

Certain glasses for glass substrate 1 (which or may not be patterned in different instances) according to example embodiments of this invention utilize soda-lime-silica flat glass as their base composition/glass. In addition to base composition/glass, a colorant portion may be provided in order to achieve a glass that is fairly clear in color and/or has a high visible transmission. An exemplary soda-lime-silica base glass according to certain embodiments of this invention, on a weight percentage basis, includes the following basic ingredients: SiO₂, 67-75% by weight; Na₂O, 10-20% by weight; CaO, 5-15% by weight; MgO, 0-7% by weight; Al₂O₃, 0-5% by weight; K₂O, 0-5% by weight; Li₂O, 0-1.5% by weight; and BaO, 0-1%, by weight.

Other minor ingredients, including various conventional refining aids, such as SO₃, carbon, and the like may also be included in the base glass. In certain embodiments, for example, glass herein may be made from batch raw materials silica sand, soda ash, dolomite, limestone, with the use of sulfate salts such as salt cake (Na₂SO₄) and/or Epsom salt (MgSO₄ x 7H₂O) and/or gypsum (e.g., about a 1:1 combination of any) as refining agents. In certain example embodiments, soda-lime-silica based glasses herein include by weight from about 10-15% Na₂O and from about 6-12% CaO, by weight.

In addition to the base glass above, in making glass according to certain example embodiments of the instant invention the glass batch includes materials (including colorants and/or oxidizers) which cause the resulting glass to be fairly neutral in color (slightly yellow in certain example embodiments, indicated by a positive b* value) and/or have a high visible light transmission. These materials may either be present in the raw materials (e.g., small amounts of iron), or may be added to the base glass materials in the batch (e.g., cerium, erbium and/or the like). In certain example embodiments of this invention, the resulting glass has visible transmission of at least 75%, more preferably at least 80%, even more preferably of at least 85%, and most preferably of at least about 90% (Lt D65). In certain example non-limiting instances, such high transmissions may be achieved at a reference glass thickness of about 3 to 4 mm In certain embodiments of this invention, in addition to the base glass, the glass and/or glass batch comprises or consists essentially of materials as set forth in Table 1 below (in terms of weight percentage of the total glass composition):

**Table 1: Example Additional Materials In Glass**

| Ingredient | General (Wt.%) | More Preferred | Most Preferred |
|---|---|---|---|
| total iron (expressed as Fe₂O₃): | 0.001 - 0.06 % | 0.005 - 0.04 % | 0.01 - 0.03 % |
| cerium oxide: | 0 - 0.30% | 0.01 - 0.12 % | 0.01 - 0.07 % |
| TiO₂ | 0 - 1.0% | 0.005 - 0.1% | 0.01 - 0.04 % |
| Erbium oxide: | 0.05 to 0.5% | 0.1 to 0.5% | 0.1 to 0.35% |

In certain example embodiments, the total iron content of the glass is more preferably from 0.01 to 0.06%, more preferably from 0.01 to 0.04%, and most preferably from 0.01 to 0.03%. In certain example embodiments of this invention, the colorant portion is substantially free of other colorants (other than potentially trace amounts). However, it should be appreciated that amounts of other materials (e.g., refining aids, melting aids, colorants and/or impurities) may be present in the glass in certain other embodiments of this invention without taking away from the purpose(s) and/or goal(s) of the instant invention. For instance, in certain example embodiments of this invention, the glass composition is substantially free of, or free of, one, two, three, four or all of: erbium oxide, nickel oxide, cobalt oxide, neodymium oxide, chromium oxide, and selenium. The phrase "substantially free" means no more than 2 ppm and possibly as low as 0 ppm of the element or material. It is noted that while the presence of cerium oxide is preferred in many embodiments of this invention, it is not required in all embodiments and indeed is intentionally omitted in many instances. However, in certain example embodiments of this invention, small amounts of erbium oxide may be added to the glass in the colorant portion (e.g., from about 0.1 to 0.5% erbium oxide).

The total amount of iron present in the glass batch and in the resulting glass, i.e., in the colorant portion thereof, is expressed herein in terms of Fe₂O₃ in accordance with standard practice. This, however, does not imply that all iron is actually in the form of Fe₂O₃ (see discussion above in this regard). Likewise, the amount of iron in the ferrous state (Fe⁺²) is reported herein as FeO, even though all ferrous state iron in the glass batch or glass may not be in the form of FeO. As mentioned above, iron in the ferrous state (Fe²⁺; FeO) is a blue-green colorant, while iron in the ferric state (Fe³⁺) is a yellow-green colorant; and the blue-green colorant of ferrous iron is of particular concern, since as a strong colorant it introduces significant color into the glass which can sometimes be undesirable when seeking to achieve a neutral or clear color.

It is noted that the light-incident surface of the glass substrate 1 may be flat or patterned in different example embodiments of this invention.

Fig. 2 is a cross-sectional view of a photovoltaic device (e.g., solar cell), for converting light to electricity, according to an example embodiment of this invention. The solar cell of Fig. 2 uses the AR coating 3 and glass substrate 1 shown in Fig. 1 in certain example embodiments of this invention. In this example embodiment, the incoming or incident light from the sun or the like is first incident on surface treatment layer 3b of the AR coating 3, passes therethrough and then through layer 3a and through glass substrate 1 and front transparent electrode 4 before reaching the photovoltaic semiconductor (active film) 5 of the solar cell. Note that the solar cell may also include, but does not require, a reflection enhancement oxide and/or EVA film 6, and/or a back metallic contact and/or reflector 7 as shown in example Fig. 2. Other types of photovoltaic devices may of course be used, and the Fig. 2 device is merely provided for purposes of example and understanding. As explained above, the AR coating 3 reduces reflections of the incident light and permits more light to reach the thin film semiconductor film 5 of the photovoltaic device thereby permitting the device to act more efficiently.

While certain of the AR coatings 3 discussed above are used in the context of the photovoltaic devices/modules, this invention is not so limited. AR coatings according to this invention may be used in other applications such as for picture frames, fireplace doors, greenhouses, and the like. Also, other layer(s) may be provided on the glass substrate under the AR coating so that the AR coating is considered on the glass substrate even if other layers are provided therebetween. Also, while the first layer 3 a is directly on and contacting the glass substrate 1 in the Fig. 1 embodiment, it is possible to provide other layer(s) between the glass substrate and the first layer in alternative embodiments of this invention.

Long chain organic materials having reactive end groups based on silicon and phosphorous may form self-assembled monolayers on glass surfaces. Silanes containing short organic chains such as methyl trichlorosilane may be used to produce monolayers of coatings (e.g., first layer 3a) on glass surface. While the reactive functional groups may form chemical bonds to the hydroxyl groups present on glass surface, the organic chains may point away from the glass surface, possibly resulting in a change of surface characteristics of the glass.

Thus the hydrophilic nature of the glass surface may change to hydrophobic in nature. This may cause high contact angles for water droplets. Organic chains containing fluorine atoms may also produce similar effects on glass surface. In addition to altering the chemical nature of the surface, these coatings may impart lubricity to surface which can result in a lower coefficient of friction as well as enhanced scratch resistance.

In certain embodiments, the protective top layer may not substantially or materially alter the overall optical characteristics or significantly adversely affect reflection and/or transmission properties of mono-layered AR coatings. Thus, in certain embodiments, thickness and refractive index of the protective top coat (i.e., the surface treatment layer) may be important, and it is generally preferable that the protective top coat is applied as a very thin layer from materials that form coatings having minimum absorption in the interested wavelength range.

In certain embodiments, the organic materials comprise an alkyl chain or a fluoro-alkyl chain and at least one reactive functionality comprising silicon and/or phosphorous. This may include, for example, short and long alkyl chains that may or may not contain fluorine. In some embodiments, reactive functionalities are optional but preferable in order to chemically bond the organic materials to AR surface. In certain embodiments, there may be more than one alkyl chain attached to one reactive functionality or vice-versa.

Reference examples of organic materials containing alkyl chains or fluoro-alkyl chains and reactive functionalities comprising silicon and/or phosphorous for the surface treatment layer may include octadecyl trichlorosilane, octadecyl triethoxy silane, methyl trichlorosilane, dipodal silanes having dual reactive sites, such as bis(triethoxysilyl)decane, tridecafluoro tetrahydrooctyl trichlorosilane, tridecafluoro tetrahydrooctyl triethoxy silane (available from Gelest), methyl phosphonic acid (available from Alfa Aesar), etc. Other examples of preferred materials may include fluorinated polyether materials available from Solvay Solexis, such as perfluoropolyethers containing reactive silane groups (Fluorolink S10), perfluoropolyether based polyurethane dispersions (Fluorolink P56), diphosphate derivatives of perfluoropolyether in acid form or as ammonium salt (Fluorolink F10 and F10A) (see http://www.solvaysolexis.com/products/bybrand/brand/0,,16051-2-0,00.htm), microemulsions of hydroalcoholic perfluoropolyether (Fomblin FE20C), Fomblin Z derivatives used for magnetic disk protection, etc., (http://www.solvaysolexis.com/products/bybrand/brand/0"16048-2-0,00.htm).

Dilute solutions or dispersions of coating materials in aqueous or non-aqueous media may be applied by any conventional wet application techniques. A preferred method involves application of a dilute coating formulation by spray process on the AR coating surface immediately after the coated glass emerges from a tubular furnace such as tempering line, etc. Concentration of spray coating formulation and the dwell time of the wet coating on the AR coating surface may be varied to get maximum packing density of monolayers. In addition thermal energy may be applied to further enhance coating process.

Exemplary embodiments of this invention provide a new method to produce a low index silica coating for use as the AR coating 3, with appropriate light transmission and abrasion resistance properties. Exemplary embodiments of this invention provide a method of making a coating containing a stabilized colloidal silica for use in coating 3. In certain example embodiments of this invention, the coating may be based; at least in part, on a silica sol comprising two different silica precursors, namely (a) a stabilized colloidal silica including or consisting essentially of particulate silica in a solvent and (b) a polymeric solution including or consisting essentially of silica chains.

In accordance with certain embodiments of the present invention, suitable solvents may include, for example, n-propanol, isopropanol, other well-known alcohols (e.g., ethanol), and other well-known organic solvents (e.g., toluene).

In exemplary embodiments, silica precursor materials may be optionally combined with solvents, anti-foaming agents, surfactants, etc., to adjust rheological characteristics and other properties as desired. In a preferred embodiment, use of reactive diluents may be used to produce formulations containing no volatile organic matter. Some embodiments may comprise colloidal silica dispersed in monomers or organic solvents. Depending on the particular embodiment, the weight ratio of colloidal silica and other silica precursor materials may be varied. Similarly (and depending on the embodiment), the weight percentage of solids in the coating formulation may be varied.

Several examples were prepared, so as to illustrate exemplary embodiments of the present invention. Although the examples describe the use of the spin-coating method, the uncured coating may be deposited in any suitable manner, including, for example, not only by spin-coating but also roller-coating, spray-coating, and any other method of depositing the uncured coating on a substrate.

In certain exemplary embodiments, the firing may occur in an oven at a temperature ranging preferably from 550 to 700°C (and all subranges therebetween), more preferably from 575 to 675°C (and all subranges therebetween), and even more preferably from 600 to 650°C (and all subranges therebetween). The firing may occur for a suitable length of time, such as between 1 and 10 minutes (and all subranges therebetween) or between 3 and 7 minutes (and all subranges therebetween).

In certain exemplary embodiments, the surface treatment composition includes (a) an organic material comprising an alkyl chain or a fluoro-alkyl chain and at least one reactive functionality comprising silicon and/or phosphorous and (b) a solvent. Preferably the surface treatment composition is dilute and has a molarity between 0.0001 and 0.01M (and all subranges therebetween); more preferably between 0.002 and 0.008M (and all subranges therebetween); and even more preferably between 0.004 and 0.006M (and all subranges therebetween).

Set forth below is a description of how AR coating 3 may be made according to certain example non-limiting embodiments of this invention.

### Example #1

Preparation of porous silica coating: A monolayer AR coating was deposited on sodalime glass by the method described in U.S. Patent App. No. 11/878,790. A liquid coating composition was prepared by mixing 0.6 gm 30 wt% dispersion of colloidal silica MEK-ST obtained from Nissan Chemical, 0.5 gm methacryloylpropoxy trimethoxy silane, and 18.9 gm of a commercial UV cure acrylic resin UVB370 obtained from Red Spot. The resulting coating composition contained 1.5% of total silica by weight of which about 60% by weight was colloidal silica and the rest in the form of silane. Liquid coating was deposited on a sodalime glass substrate by spin coating technique at 3000 rpm for 30 seconds and exposed to UV radiation for about 45 seconds to cure the film. The coated glass substrate was then fired at about 625°C for about 5 minutes to obtain a porous silica coating. The coating thickness was measured to be 7.05 microns after UV curing and after firing the thickness of the porous silica coating was 141 mn.

Surface treatment: A dilute solution of about 0.0005 molar octadecylphosphonic acid (ODPA) in n-propanol was prepared and applied to about one half of the sodalime glass substrate on the side previously coated with porous silica coating. The solution of ODPA was applied by flow coating means and after about 30s of dwell time the solution was blown off with dry nitrogen to change the surface characteristics of porous silica coating. It was noticed that the coefficient of friction on the section of porous silica coating which was treated with ODPA significantly decreased and scratch resistance increased as compared to the untreated section.

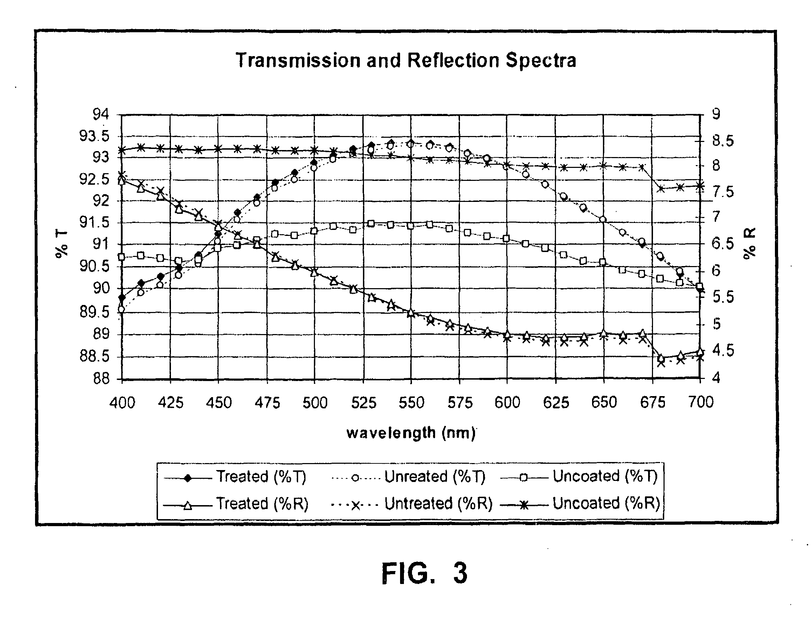

Optical characteristics: Transmission and reflection spectra of coated glass substrate in both the surface treated and untreated sections were measured. As shown in Figure 3, the porous silica coating suppressed surface reflection of the sodalime uncoated glass while the transmission significantly enhanced. Also it can be seen that the surface treatment affected as described above did not alter the transmission or the reflection of porous silica coating. That is, the low-index coating has a percent transmission and/or percent reflection that is not substantially affected by the overcoat layer comprising the organic material comprising an alkyl chain or a fluoro-alkyl chain and at least one reactive functionality comprising silicon and/or phosphorous.

All described and claimed numerical values and ranges are approximate and include at least some degree of variation.

While the invention has been described in connection with what is presently considered to be the most practical and preferred embodiment, it is to be understood that the invention is not to be limited to the disclosed embodiment, but on the contrary, is intended to cover various modifications and equivalent arrangements included within the scope of the appended claims.

## Claims

1. A method of making a low-index silica based coating, the method comprising:
forming a silica precursor comprising a silica sol comprising a silane and/or a colloidal silica;
depositing the silica precursor on a glass substrate to form a coating layer;
curing and/or firing the coating layer in an oven at a temperature of from about S50 to 700°C for a duration of from about 1 to 10 minutes;
forming a surface treatment composition comprising octadecyl phosphonic acid;
depositing the surface treatment composition on the coating layer; and
curing and/or firing the surface treatment composition to form an overcoat layer.

2. The method of claim 1, wherein the silica precursor further comprises a radiation curable composition comprising a radiation curable monomer and a photoinitiator.

3. The method of claim 1, wherein the surface treatment composition further comprises a solvent and has a molarity ranging between 0.0001 and 0.01 M, and preferably a molarity ranging between 0.002 and 0.008M

4. A method of making a photovoltaic device comprising a photoelectric transfer film, at least one electrode, and the low-index coating, wherein the method of making the photovoltaic device comprises making the low-index coating according to claim 1, and wherein the low-index coating is provided on a light incident side of a front glass substrate of the photovoltaic device.

5. A photovoltaic device comprising:
a photovoltaic film, and at least a glass substrate (1) on a light incident side of the photovoltaic film;
an antireflection coating (3) provided on the glass substrate (1);
wherein the antireflection coating (3) comprises at least a layer provided directly on and contacting the glass substrate, the layer produced using a method comprising the steps of: forming a silica precursor comprising a silica sol comprising a silane and/or a colloidal silica; depositing the silica precursor on a glass substrate to form a coating layer; curing and/or firing the coating layer in an oven at a temperature of from about 550 to 700°C for a duration of from about 1 to 10 minutes; forming a surface treatment composition comprising octadecyl phosphonic acid; depositing the surface treatment on the coating layer; curing and/or firing the surface treatment to form an overcoat layer; and using the glass substrate with the low-index silica based coating thereon as a front glass substrate of the photovoltaic device so that the low-index silica based coating is provided on a light incident side of the glass substrate.

## Patentansprüche

1. Ein Verfahren zum Herstellen einer auf Siliziumdioxid basierenden Niedrigindexbeschichtung, wobei das Verfahren aufweist:
Erzeugen eines Siliziumdioxidpräkursors, der ein Siliziumdioxidsol aufweist, das ein Silan und/oder ein kolloidales Siliziumdioxid aufweist;
Ablagern des Siliziumdioxidpräkursors auf ein Glassubstrat um eine Beschichtungsschicht zu erzeugen;
Aushärten und/oder Brennen der Beschichtungsschicht in einem Ofen bei einer Temperatur von etwa 550 bis 700°C für eine Dauer von etwa 1 bis 10 Minuten;
Erzeugen einer Zusammensetzung zur Oberflächenbehandlung, die Octadecyl-Phosphonsäure aufweist;
Ablagern der Zusammensetzung zur Oberflächenbehandlung auf der Beschichtungsschicht; und Aushärten und/oder Brennen der Zusammensetzung zur Oberflächenbehandlung um eine Überzugsschicht zu erzeugen.

2. Verfahren gemäß Anspruch 1, wobei der Siliziumdioxidpräkursor weiterhin eine strahlungshärtbare Zusammensetzung aufweist, die einen strahlungshärtbaren Monomer und einen Photoinitiator aufweist.

3. Das Verfahren gemäß Anspruch 1, wobei die Zusammensetzung zur Oberflächenbehandlung weiter ein Lösungsmittel aufweist und eine Molarität die sich zwischen 0.0001 und 0.01 M bewegt, und vorzugsweise eine Molarität die sich zwischen 0.002 und 0.008 M bewegt.

4. Ein Verfahren zum Herstellen einer photovoltaischen Vorrichtung die einen photoelektrischen Transferfilm aufweist, zumindest eine Elektrode, und die Niedrigindexbeschichtung, wobei das Verfahren zum Herstellen der photovoltaischen Vorrichtung das Herstellen der Niedrigindexbeschichtung gemäß Anspruch 1 aufweist, und wobei die Niedrigindexbeschichtung an einer Lichteinfallsseite von einem Frontglassubstrat von der photovoltaischen Vorrichtung angeordnet ist.

5. Eine photovoltaische Vorrichtung aufweisend:
einen photovoltaischen Film, und zumindest ein Glassubstrat (1) an einer Lichteinfallsseite von dem photovoltaischen Film;
eine Antireflektionsbeschichtung (3) angeordnet an dem Glassubstrat (1);
wobei die Antireflektionsbeschichtung (3) zumindest eine Schicht aufweist, die direkt auf und in Kontakt mit dem Glassubstrat angeordnet ist, wobei die Schicht hergestellt ist durch ein Verfahren dass die folgenden Schritte aufweist: Erzeugen eines Siliziumdioxidpräkursors, der ein Siliziumdioxidsol aufweist, das ein Silan und/oder ein kolloidales Siliziumdioxid aufweist;
Ablagern des Siliziumdioxidpräkursors auf ein Glassubstrat um eine Beschichtungsschicht zu erzeugen; Aushärten und/oder Brennen der Beschichtungsschicht in einem Ofen bei einer Temperatur von etwa 550 bis 700°C für eine Dauer von etwa 1 bis 10 Minuten; Erzeugen einer Zusammensetzung zur Oberflächenbehandlung aufweisend Octadecyl-Phosphonsäure;
Ablagern der Oberflächenbehandlung auf der Beschichtungsschicht; Aushärten und/oder Brennen der Oberflächenbehandlung um eine Überzugsschicht zu erzeugen;
und Benutzen des Glassubstrats mit der auf Siliziumdioxid basierenden Niedrigindexbeschichtung darauf als Frontglassubstrat von der photovoltaischen Vorrichtung, so dass die auf Siliziumdioxid basierende Niedrigindexbeschichtung an einer Lichteinfallsseite des Glassubstrats angeordnet ist.

## Revendications

1. Un procédé de fabrication d'un revêtement à base de silice à faible indice, le procédé comprenant :
la formation d'un précurseur de la silice comprenant un sol de silice comprenant un silane et/ou une silice colloïdale ;
le dépôt du précurseur de silice sur un substrat en verre pour former une couche de revêtement ;
le durcissement et/ou la cuisson de la couche de revêtement dans un four à une température allant d'environ 550 à 700°C pendant une durée allant d'environ 1 à 10 minutes ;
la formation d'une composition de traitement de surface comprenant de l'acide octadécylphosphonique ;
le dépôt de la composition de traitement de surface sur la couche de revêtement ; et
le durcissement et/ou la cuisson de la composition de traitement de surface pour former une couche de recouvrement.

2. Le procédé de la revendication 1, dans lequel le précurseur de silice comprend en outre une composition durcissable aux rayonnements comprenant un monomère durcissable aux rayonnements et un photo-initiateur.

3. Le procédé de la revendication 1, dans lequel la composition de traitement de surface comprend en outre un solvant et présente une molarité comprise entre 0,0001 et 0,01 M, et de préférence une molarité comprise entre 0,0002 et 0,008 M.

4. Un procédé de fabrication d'un composant photovoltaïque comprenant un film de transfert photoélectrique, au moins une électrode, et le revêtement à faible indice, dans lequel le procédé de fabrication du composant photovoltaïque comprend la fabrication du revêtement à faible indice selon la revendication 1, et dans lequel le revêtement à faible indice est formé sur un côté frappé par la lumière incidente d'un substrat frontal en verre du composant photovoltaïque.

5. Un composant photovoltaïque comprenant :
un film photovoltaïque, et au moins un substrat en verre (1) sur un côté frappé par la lumière du film photovoltaïque ;
un revêtement anti-réfléchissant (3) formé sur le substrat en verre (1) ;
dans lequel le revêtement anti-réfléchissant (3) comprend au moins une couche formée directement sur et venant en contact avec le substrat en verre, la couche étant produite en utilisant un procédé comprenant les étapes de : formation d'un précurseur de la silice comprenant un sol de silice comprenant un silane et/ou une silice colloïdale ; dépôt du précurseur de silice sur un substrat en verre pour former une couche de revêtement ;
durcissement et/ou cuisson de la couche de revêtement dans un four à une température allant d'environ 550 à 700°C pendant une durée allant d'environ 1 à 10 minutes ;
formation d'une composition de traitement de surface comprenant de l'acide octadécylphosphonique ; dépôt de la composition de traitement de surface sur la couche de revêtement ; durcissement et/ou cuisson de la composition de traitement de surface pour former une couche de recouvrement ; et utilisation du substrat en verre avec dessus le revêtement à base de silice à faible indice comme substrat frontal en verre du composant photovoltaïque de sorte que le revêtement à base de silice à faible indice soit formé sur un côté frappé par la lumière du substrat en verre.
